Europäisches Patentamt

European Patent Office

Office européen des brevets

(19)

(11) Veröffentlichungsnummer: **0 177 803 B1**

(12) **EUROPÄISCHE PATENTSCHRIFT**

(45) Veröffentlichungstag der Patentschrift: **29.05.91**

(51) Int. Cl.⁵: **H03M 1/12, H03M 1/14**

(21) Anmeldenummer: **85111624.4**

(22) Anmeldetag: **13.09.85**

(54) **Verfahren und Anordnung zum hochauflösenden Digitalisieren eines Signales.**

(30) Priorität: **14.09.84 DE 3433898**

(43) Veröffentlichungstag der Anmeldung:
**16.04.86 Patentblatt 86/16**

(45) Bekanntmachung des Hinweises auf die
Patenterteilung:
**29.05.91 Patentblatt 91/22**

(84) Benannte Vertragsstaaten:
**DE FR GB IT SE**

(56) Entgegenhaltungen:
**EP-A- 0 072 144**
**FR-A- 1 481 960**
**US-A- 3 516 085**
**US-A- 4 204 198**
**US-A- 4 251 802**

(73) Patentinhaber: **Siemens Elema AB**
**Röntgenvägen 2**
**S-171 95 Solna 1(SE)SE**

Patentinhaber: **Siemens Aktiengesellschaft**
**Wittelsbacherplatz 2**
**W-8000 München 2(DE)DE FR GB IT**

(72) Erfinder: **Elmqvist, Hakan, Dr.**
**Sunnerdahlsvägen 7**
**S-161 38 Bromma(SE)**

**Beschreibung**

Die Erfindung betrifft ein Verfahren zum hochauflösenden Digitalisieren eines Signals mit einem großen Dynamikbereich mittels eines Analog/Digital-Wandlers (A/D-Wandler), dessen Meßgebiet kleiner als der Dynamikbereich des Signals ist, wobei der Dynamikbereich des Signals in kleinere Meßabschnitte mit jeweils gleicher Größe wie das Meßgebiet des A/D-Wandlers eingeteilt wird und wobei mit Ausgangsinformationen des A/D-Wandlers ein Meßabschnittswähler derart gesteuert wird, daß das zu digitalisierende Signal in dem ausgewählten Meßabschnitt liegt und jeweils ein benachbarter Meßabschnitt gewählt wird, wenn das Signal vorgegebene Grenzwerte des jeweils aktuellen Meßabschnittes über- oder unterschreitet.

Bei einem derartigen, aus der EP-A-0 072 144 bekannten Verfahren wird ein zu digitalisierendes Signal einem A/D-Wandler zugeführt, dessen Meßgebiet nur einen Teil des Dynamikbereiches des Signals umfaßt und dessen Aufbau wegen der reduzierten Bitzahl entsprechend einfach und kostengünstig ist. Um dennoch das Signal in seinem gesamten Dynamikbereich mit der Auflösung des A/D-Wandlers bezogen auf sein Meßgebiet digitalisieren zu können, wird der Dynamikbereich in der Größe des Meßgebietes des A/D-Wandlers entsprechende Meßabschnitte aufgeteilt. Die Ausgangsinformationen des A/D-Wandlers werden daraufhin überwacht, ob das Signal in seinem aktuellen Meßabschnitt die Grenzen des Meßbereichs des A/D-Wandlers überschreitet. In diesem Fall wird ein benachbarter Meßabschnitt des zu digitalisierenden Signals ausgewählt, indem das zu digitalisierende Signal über einen D/A-Wandler und einen Differenzverstärker mit einer Spannung beaufschlagt wird, die das Signal in das Meßgebiet des A/D-Wandlers verschiebt. Die nunmehr erhaltenen Ausgangsinformationen des A/D-Wandlers werden um den Digitalwert korrigiert, mit dem der D/A-Wandler beaufschlagt wurde, so daß der korrekte Digitalwert des Signals erhalten wird. An den Schnittstellen zwischen den einzelnen Meßabschnitten können jedoch Diskontinuitäten in den Ausgangsinformationen entstehen, da die Genauigkeit des D/A-Wandlers zur Einstellung der Lage des jeweiligen Meßabschnittes im Dynamikbereich des Signals nicht der hochauflösenden Genauigkeit des A/D-Wandlers entspricht.

Bei einem anderen, aus der US-A-4,251,802 bekannten Verfahren werden zur Auswahl der Meßabschnitte statt eines D/A-Wandlers zwei Festspannungsquellen unterschiedlicher Polarität verwendet, mit denen zwar ggf. eine genaue Einstellung der Lage der ausgewählten Meßabschnitte möglich ist, aber die Unterteilung des Dynamikbereiches des zu digitalisierenden Signals auf drei Meßabschnitte begrenzt ist.

Schließlich wirkt sich bei beiden bekannten Verfahren ungünstig auf die Digitalisierungsgeschwindigkeit aus, daß das zu digitalisierende Signal bei einem Meßabschnittswechsel den A/D-Wandler zweimal durchläuft, nämlich ein erstes Mal, um ein Überschreiten der Grenzen des Wandlermeßbereichs festzustellen, und ein zweites Mal zur Digitalisierung des Signals in dem neuen Meßabschnitt.

Der Erfindung liegt die Aufgabe zugrunde, eine möglichst schnelle und genaue Digitalisierung des Signals über seinen gesamten Dynamikbereich zu ermöglichen.

Gemäß der Erfindung wird die Aufgabe dadurch gelöst, daß bei dem Verfahren der eingangs angegebenen Art einander überlappende Meßabschnitte verwendet werden, daß das Signal beim Über- bzw. Unterschreiten der Grenzwerte in dem jeweils aktuellen Meßabschnitt in einen Grenzbereich desselben Meßabschnittes gelangt und in diesem digitalisiert wird, wobei erst für die nächste Digitalisierung des Signals ein benachbarter neuer Meßabschnitt gewählt wird und daß zumindest aus den beiden zuletzt vor dem Wechsel des Meßabschnittes erhaltenen digitalen Ausgangsinformationen des A/D-Wandlers ein Digitalwert extrapoliert wird, der als Referenzwert für die nachfolgend in dem neuen Meßabschnitt digitalisierten Signalwerte verwendet wird.

Durch die Überlappung der Meßabschnitte ist zunächst einmal sichergestellt, daß das umzuwandelnde Signal sicher in einen Meßabschnitt fällt. Diskontinuitäten bei einem Wechsel des verwendeten Meßabschnittes werden weitgehend dadurch eliminiert, daß zumindest aus den beiden letzten Ausgangsinformationen des A/D-Wandlers ein neuer digitaler Signalwert extrapoliert wird. Im einfachsten Fall kann es sich um eine lineare Extrapolation zwischen den letzten beiden Werten handeln. Es können aber auch mehrere Infomationswerte verwendet werden und ein Algorithmus, der dem tatsächlichen Kurvenverlauf besser angepaßt ist. Liegt die Abtastfrequenz des A/D-Wandlers im Verhältnis zum Frequenzbereich des umzuwandelnden Signals ausreichend hoch, so kann der Fehler zwischen dem tatsächlichen Signalwert und dem aus den vorherigen extrapolierten hinreichend klein gemacht werden. Der extrapolierte Signalwert stellt damit eine Referenz für die folgenden Signalwerte in dem neuen Meßabschnitt dar.

Mit Hilfe dieses Verfahrens ist es also mit einem schnellen und preiswerten A/D-Wandler möglich, bei praktisch gleichbleibend hoher Auflösung die Digitalisierung eines Signals über den gesamten Meßbereich vorzunehmen. Der extrapolierte Signalwert kann dabei direkt als erster Wert im geänderten Meßabschnitt verwendet werden, d.h. also an der eigentlich mit Unsicherheiten hinsichtlich der Meßgenauigkeit behafteten Schnittstelle.

Die konsekutiven Differenzen der Signale können damit unabhängig von der absoluten Lage des Meßabschnittes im totalen Meßbereich gemessen werden. Das gewünschte Ausgangssignal, d.h. der gewünschte Digitalwert, wird durch Addition dieser Differenzen gewonnen, jedoch ohne absolute Referenz.

In einer Weiterbildung der Erfindung ist dabei vorgesehen, daß der unmittelbar nach dem Ändern des Meßabschnittes gemessene und nicht extrapolierte Signalwert Ausgangswert für die nächste Differenzbildung ist.

Zur Absolutwertmessung kann der mögliche Fehler an den Schnittstellen zwischen den Meßabschnitten dadurch eliminiert werden, daß die Differenz aus dem extrapolierten Digitalwert und dem ersten im neuen Meßabschnitt gemessenen Signalwert gebildet und zur Korrektur der Lage und damit der Signalwerte dieses Meßabschnittes verwendet wird. Der jeweilige Absolutwert für die Signalwerte wird aus diesem korrigierten Signalwert in Verbindung mit dem Wert über die Lage des Abschnittes erhalten.

Die Durchführung des erfindungsgemäßen Verfahrens erfolgt in vorteilhafter Weise durch eine Anordnung zum hochauflösenden Digitalisieren eines Signals mit einem großen Dynamikbereich mittels eines A/D-Wandlers, dessen Meßgebiet kleiner als der in gleichgroße Meßabschnitte unterteilte Dynamikbereich des Signals ist, mit einer die Ausgangsinformationen des A/D-Wandlers erhaltenden Logikstufe zur Erkennung, wenn das Signal vorgegebene Grenzwerte des jeweils aktuellen Meßabschnittes überschreitet, und mit einem Meßabschnittswähler, in dem bei einer Grenzwertüber- oder-unterschreitung zur Auswahl eines nächsten Meßabschnittes ein D/A-Wandler von der Logikstufe angesteuert wird und ein dem A/D-Wandler vorgeordneter Differenzverstärker an einem Eingang mit dem zu digitalisierenden Signal beaufschlagt und an dem anderen Eingang mit dem Ausgang des D/A-Wandlers verbunden ist, bei dem gemäß der Erfindung vorgesehen ist, daß die Logikstufe Mittel zur Extrapolation eines Digitalwertes aus zumindest den letzten beiden vor der Umschaltung in den jeweils neuen Meßbereich digitalisierten Signalwerten enthält und Mittel zur Korrektur der in dem neuen Meßabschnitt digitalisierten Signalwerte in Abhängigkeit von dem extrapolierten Digitalwert aufweist.

All diese Maßnahmen können besonders vorteilhaft mit Hilfe eines Mikroprozessors vorgesehen sein. In einer vorteilhaften Weiterbildung der Erfindung kann es vorgesehen sein, daß der A/D-Wandler über den D/A-Wandler kalibriert ist.

Im folgenden wird ein Ausführungsbeispiel der Erfindung anhand von 5 Figuren näher beschrieben und erläutert. Dabei zeigen

FIG 1    in einem Blockschaltbild schematisch eine Anordnung zum Digitalisieren eines Signals,

FIG 2    im unteren Teil einen angenommenen analogen Signalverlauf über der Zeit und im oberen Teil in einem vergrößerten Ausschnitt die mögliche Lage und Veränderung des Meßabschnitte,

FIG 3    in einem entsprechenden Ausschnitt die theoretische und praktische Lage der Meßabschnitte und der Meßpunkte,

FIG 4    in etwas detaillierter Form die Anordnung gemäß FIG 1 und schließlich

FIG 5    ein Flußdiagramm zur Kontrolle der in der Anordnung gemäß FIG 4 ablaufenden Vorgänge.

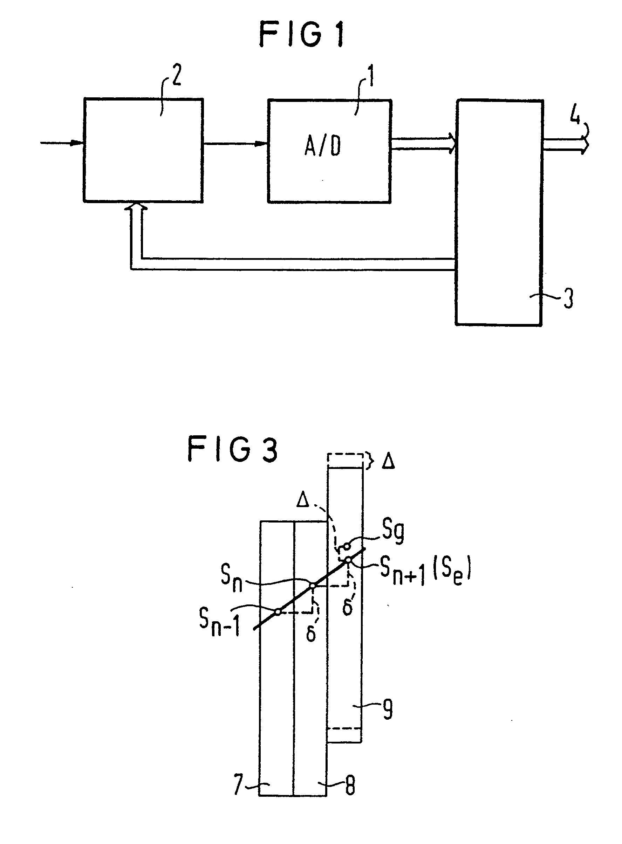

Im Blockschaltbild gem. FIG 1 ist mit (1) ein A/D-Wandler bezeichnet, dem das umzuwandelnde Signal über einen Meßabschnittswähler (2) zugeführt wird. Das Ausgangssignal des A/D-Wandlers (1) gelangt auf eine Logikstufe (3), die zum einen den Meßabschnittswähler (2) ansteuert und zum anderen das gewünschte Digitalsignal über eine Ausgangsleitung (4) abgibt.

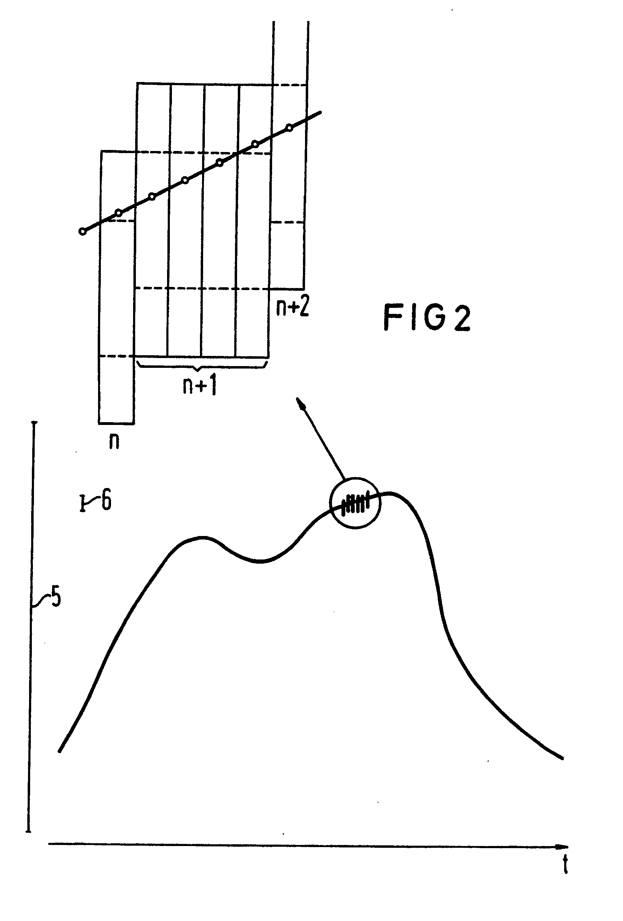

In FIG 2 ist im unteren Teil über der Zeit (t) ein möglicher analoger Signalverlauf aufgetragen. Die Strecke (5) soll dabei den totalen Meßbereich, d.h. den Dynamikbereich andeuten. Die daneben im gleichen Maßstab dargestellte Säule (6) gibt die Größe des verwendeten Meßabschnittes wieder. Im mittleren Bereich des Signals sind eine Reihe von aneinanderstoßenden Meßabschnitten entlang der Kurve dargestellt. Wie man bereits daraus ersehen kann, überlappen sich die einzelnen Meßabschnitte.

Im oberen Teil der FIG 2 ist dieser Abschnitt vergrößert dargestellt. Der Einfachheit halber ist ein Abschnitt gewählt, in dem das umzuwandelnde Signal einen linearen Verlauf hat. Der linke Meßabschnitt sei beispielsweise mit "n" bezeichnet. Die vier folgenden mit "n + 1" und der letzte rechte Meßabschnitt "n + 2". Wie man in diesem vergrößerten Ausschnitt sehen kann, geschieht ein Wechsel zum nächsten Meßabschnitt "n + 2" jeweils, wenn der Meßwert in den Grenzbereich - gestrichelt angedeutet - des Meßabschnittes "n + 1" gelangt. Die unterschiedlichen Meßabschnitte überlappen sich in diesem Ausführungsbeispiel um jeweils 3/4 der Größe der Meßabschnitte. Im Rahmen der Erfindung sind auch andere Verschiebungen der Meßabschnitte möglich. Ist das umzuwandelnde Signal kleiner als 1/4 der Größe des Meßabschnittes oder größer als 3/4 dieser Größe, so wird der Meßabschnittswähler (2) einen anderen Meßabschnitt wählen, der entweder eine Stufe nach unten oder eine Stufe nach oben verschoben ist. Solange sich das Signal im mittleren Bereich der Meßabschnitte bewegt, werden diese unverändert beibehalten.

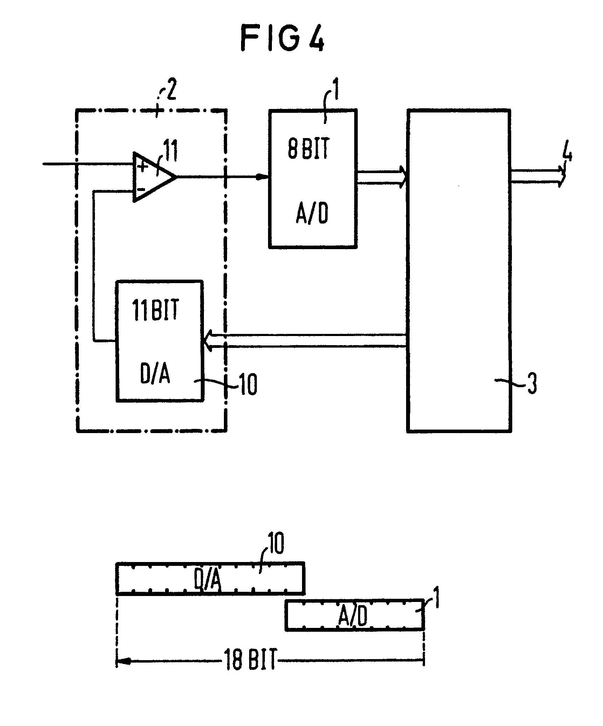

Anhand der folgenden FIG 3 soll noch einmal das erfindungsgemäße Verfahren etwas näher erläutert werden. Dargestellt sind wiederum drei Meßabschnitte (7 - 9) sowie drei Signalwerte $S_{n-1}$, $S_n$ und $S_{n+1}$. Angenommen ist wieder ein linearer Signalverlauf. Angenommen ist weiterhin, daß der Meßwert $S_n$ im Grenzbereich des Meßabschnittes (8) liegt und daher ein Wechsel des Meßabschnittes vorgenommen wird. Gestrichelt ist der theoretisch korrekt verschobene Meßabschnitt (9) dargestellt. Mit durchgezogenen Linien hingegen ist die durch den möglichen Fehler des Meßabschnittwählers (2) hervorgerufene tatsächliche Lage des Meßabschnittes (9) dargestellt. Mit $S_e$ ist der extrapolierte Signalwert bezeichnet, der auch unter Vernachlässigung des Fehlers bei der Extrapolation dem tatsächlichen Signalwert entspricht. Mit $S_g$ ist der durch den fehlerhaft liegenden Meßabschnitt gemessene Signalwert bezeichnet, der erheblich von dem tatsächlichen Signalwert abweichen kann. Mit δ sind hier zusätzlich die Differenzen zwischen benachbarten Signalwerten angegeben. Δ deutet den Fehler in der Lage des geänderten Meßabschnittes an.

Wie man dieser FIG 3 anschaulich entnehmen kann, kann der zu bestimmende Signalwert entweder dadurch erhalten werden, daß die mit δ bezeichneten Differenzen zwischen benachbarten Signalwerten ständig addiert werden oder daß die mit Δ bezeichnete Differenz zwischen dem extrapoliertenund dem tatsächlich gemessenen Signalwert bestimmt und zur jeweiligen Korrektur der im neu eingestellten Meßabschnitt erhaltenen Signalwerte herangezogen wird.

In der folgenden FIG 4 sind gleiche Teile wie in FIG 1 mit gleichen Bezugszeichen versehen. In dem konkreten Beispiel soll eine Digitalisierung mit einer Auflösung von 18 Bit vorgenommen werden unter Verwendung eines 8-Bit-A/D-Wandlers (1) und eines Meßabschnittwählers (2), der aus einem 11-Bit-D/A-Wandler (10) und einem Differenzverstärker (11) besteht. Das höchstsignifikante Bit des D/A-Wandlers (1) bestimmt die Wahl des Meßabschnittes dadurch, daß der Wert des D/A-Wandlers (1) jeweils um einen Schritt verändert wird, der der Hälfte des Meßgebietes des A/D-Wandlers (1) entspricht. Im rechten unteren Teil der FIG 4 sind als zwei Säulen der A/D-Wandler (1) und der D/A-Wandler (10) noch einmal dargestellt. Zusammen überdecken die beiden Wandler (1) und (10) 18 Bit, was der geforderten Auflösung über den gesamten Dynamikbereich entspricht. Das am wenigsten signifikante Bit des D/A-Wandlers (10) liefert wegen der sehr viel höheren Referenzspannung an diesem Wandler (10) einen Analogwert, der eine Niveauverschiebung des umzuwandelnden Signals um einen Betrag im Differenzverstärker (11) hervorruft, der genau der Hälfte des Meßgebietes des A/D-Wandlers (1) entspricht. Das höchst signifikante Bit des A/D-Wandlers (1) bestimmt dabei über die Logikstufe (3) wann und in welcher Richtung der Wert des D/A-Wandlers (10) und damit der Meßabschnitt geändert werden soll.

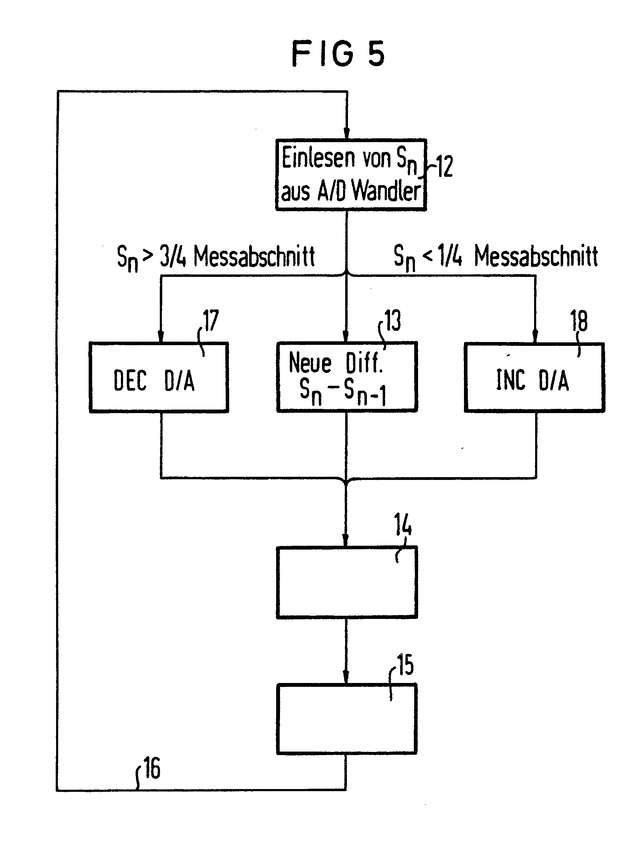

FIG 5 zeigt in einem Flußdiagramm die Kontrollstufen, die die Logikstufe gem. FIG 4 durchführt. In einem ersten Schritt werden die Informationen ($S_n$) aus dem A/D-Wandler (1) eingelesen, wie im Block (12) angedeutet. Liegt der Wert $S_n$ außerhalb des Grenzbereiches des A/D-Wandlers (1), so wird aus diesem Wert, wie in dem Block (13) angegeben, direkt eine neue Differenz zwischen diesem Wert $S_n$ und dem vorhergehenden Wert $S_{n-1}$ gebildet. Danach wird eine Umorganisation derart vorgenommen, daß der zuletzt eingegangene Wert $S_n$ der neue Wert $S_{n-1}$ wird. Kommt im nächsten Takt wieder ein Wert $S_n$ so wird erneut die Differenz gebildet und so weiter. Wie durch den Block (14) angegeben, werden diese Differenzen beispielsweise in einer Pufferstufe addiert. Über eine weitere Stufe (15) wird das jeweilige Signal dieser Pufferstufe (14), das der Summe aller Differenzen und damit dem Wechselspannungsanteil des umzuwandelnden Signals entspricht, ausgesendet. Über die Leitung (16) wird danach das Einlesen eines neuen Wertes aus dem A/D-Wandler (1) ausgelöst.

Wenn der eingelesene Wert $S_n$ größer als 3/4 des Meßabschnittes oder kleiner als 1/4 desselben ist, d.h. wenn der umzuwandelnde Wert im Grenzbereich des A/D-Wandlers (1) liegt, so ist der direkte Zugang zum Differenzbildner (13) gesperrt. Über die Blöcke (17) bzw. (18) wird in diesem Fall der Wert des D/A-Wandlers (10) entweder verringert oder erhöht. Da keine neue Differenz gebildet wird, wird die zuletzt vorliegende Differenz auf die Pufferstufe (14) gegeben und damit zu dem vorliegenden Wert hinzuaddiert. Das zweimalige Anwenden der gleichen Differenz entspricht damit einem linearen Extrapolieren zu einem neuen Signalwert.

**Ansprüche**

1. Verfahren zum hochauflösenden Digitalisieren eines Signals mit einem großen Dynamikbereich (5) mittels eines Analog/Digital-Wandlers (A/D-Wandler) (1), dessen Meßgebiet kleiner als der Dynamikbereich (15) des Signals ist, wobei der Dynamikbereich (5) des Signals in kleinere Meßabschnitte (7,8,9) mit jeweils gleicher Größe (6) wie das Meßgebiet des A/D-Wandlers (1) eingeteilt wird und wobei mit Ausgangsinformationen des A/D-Wandlers (1) ein Meßabschnittswähler (2) derart gesteuert wird, daß das zu digitalisierende Signal in dem ausgewählten Meßabschnitt (8) liegt und jeweils ein benachbarter Meßabschnitt (9) gewählt wird, wenn das Signal vorgegebene Grenzwerte des jeweils aktuellen Meßabschnittes (8) über- oder unterschreitet, **dadurch gekennzeichnet,** daß einander überlappende Meßabschnitte (7,8,9) verwendet werden, daß das Signal beim Über- bzw. Unterschreiten der Grenzwerte in dem jeweils aktuellen Meßabschnitt (8) in einen Grenzbereich desselben Meßabschnittes (8) gelangt und in diesem digitalisiert wird, wobei erst für die nächste Digitalisierung des Signals ein benachbarter neuer Meßabschnitt (9) gewählt wird und daß zumindest aus den beiden zuletzt vor dem Wechsel des Meßabschnittes (7,8,9) erhaltenen digitalen Ausgangsinformationen des A/D-Wandlers (1) ein Digitalwert extrapoliert wird, der als Referenzwert für die nachfolgend in dem neuen Meßabschnitt (9) digitalisierten Signalwerte verwendet wird.

2. Verfahren nach Anspruch 1, **dadurch gekennzeichnet,** daß der extrapolierte Signalwert als erster Wert im geänderten Meßabschnitt verwendet wird.

3. Verfahren nach Anspruch 1 oder 2, **dadurch gekennzeichnet,** daß jedesmal eine Differenz aus dem aktuellen - erfaßten oder extrapolierten - und vorhergehendenSignalwert gebildet und kontinuierlich addiert wird.

4. Verfahren nach Anspruch 3, **dadurch gekennzeichnet,** daß der unmittelbar nach dem Ändern des Meßabschnittes gemessene und nicht extrapolierte Signalwert Ausgangswert für die nächste Differenzbildung ist.

5. Verfahren nach Anspruch 1, **dadurch gekennzeichnet,** daß die Differenz aus dem extrapolierten Digitalwert und dem ersten im neuen Meßabschnitt gemessenen Signalwert gebildet und zur Korrektur der Lage dieses Meßabschnittes verwendet wird.

6. Anordnung zum hochauflösenden Digitalisieren eines Signals mit einem großen Dynamikbereich (5) mittels eines A/D-Wandlers (1), dessen Meßgebiet kleiner als der in gleichgroße Meßabschnitte (7,8,9) unterteilte Dynamikbereich (5) des Signals ist, mit einer die Ausgangsinformationen des A/D-Wandlers (1) erhaltenden Logikstufe (3) zur Erkennung, wenn das Signal vorgegebene Grenzwerte des jeweils aktuellen Meßabschnittes (8) überschreitet, und mit einem Meßabschnittswähler (2), in dem bei einer Grenzwert-über-oder - unterschreitung zur Auswahl eines nächsten Meßabschnittes (9) ein D/A-Wandler (10) von der Logikstufe (3) angesteuert wird und ein dem A/D-Wandler (1) vorgeordneter Differenzverstärker (11) an einem Eingang mit dem zu digitalisierenden Signal beaufschlagt und an dem anderen Eingang mit dem Ausgang des D/A-Wandlers (10) verbunden ist, **dadurch gekennzeichnet,** daß die Logikstufe (3) Mittel zur Extrapolation eines Digitalwertes aus zumindest den letzten beiden vor der Umschaltung in den jeweils neuen Meßbereich (9) digitalisierten Signalwerten enthält und Mittel zur Korrektur der in dem neuen Meßabschnitt (9) digitalisierten Signalwerte in Abhängigkeit von dem extrapolierten Digitalwert aufweist.

7. Anordnung nach Anspruch 6, **dadurch gekennzeichnet, daß** als Logikstufe ein Mikroprozessor vorgesehen ist.

8. Anordnung nach Anspruch 6 oder 7, **dadurch gekennzeichnet, daß** der A/D-Wandler (1) über den D/A-Wandler (10) kalibriert ist.

## Claims

1. Method for the high-resolution digitisation of a signal having a large dynamic range (5) by means of an analog/digital converter (A/D converter) (1), the measuring range of which is smaller than the dynamic range (15) of the signal, in which the dynamic range (5) of the signal is divided into smaller measurement sections (7, 8, 9) of equal size (6) to the measuring range of the A/D converter (1) in each case, and in which a measurement section selector (2) is controlled by output information items of the A/D converter (1) in such a way that the signal to be digitised lies in the selected measurement section (8) and an adjacent measurement section (9) is selected in each case when the signal exceeds or falls below predetermined limit values of the respective current measurement section (8), characterised in that mutually overlapping measurement sections (7, 8, 9) are used, in that when the signal exceeds or falls below the limit values in the respective current measurement section (8), it reaches a boundary area of the same measurement section (8) and is digitised therein, an adjacent new measurement section (9) being selected only for the next digitisation of the signal, and in that a digital value is extrapolated at least from the two digital output information items of the A/D converter (1) last obtained before the change of measurement section (7, 8, 9), which digital value is used as a reference value for the signal values subsequently digitised in the new measurement section (9).

2. Method according to Claim 1, characterised in that the extrapolated signal value is used as a first value in the changed measurement section.

3. Method according to Claim 1 or 2, characterised in that a difference is formed from the current - registered or extrapolated - and preceding signal value each time and is continuously added.

4. Method according to Claim 3, characterised in that the non-extrapolated signal value measured immediately after changing the measurement section is the starting value for the next difference formation.

5. Method according to Claim 1, characterised in that the difference is formed from the extrapolated digital value and the first signal value measured in the new measurement section and is used for correcting the position of this measurement section.

6. Apparatus for the high-resolution digitisation of a signal having a large dynamic range (5) by means of a A/D converter (1), the measuring range of which is smaller than the dynamic range (5), divided into measurement sections (7, 8, 9) of equal size, of the signal, having a logic stage (3) receiving the output information items of the A/D converter (1) for detecting when the signal exceeds given limit values of the respective current measurement section (8), and having a measurement section selector (2), in which, when the signal exceeds or falls below a limit value, a D/A converter (10) is activated by the logic stage (3) for selecting a next measurement section (9), and a differential amplifier (11) preceding the A/D converter (1) receives at one input the signal to be digitised and is connected at the other input to the output of the D/A converter (10), characterised in that the logic stage (3) contains means for extrapolating a digital value from at least the last two signal values digitised before the switchover into the respective new measuring range (9) and means for correcting the signal values digitised in the new measurement section (9) depending on the extrapolated digital value.

7. Apparatus according to Claim 6, characterised in that a microprocessor is provided as logic stage.

8. Apparatus according to Claim 6 or 7, characterised in that the A/D converter (1) is calibrated by means of the D/A converter (10).

**Revendications**

1. Procédé de numérisation à haute résolution d'un signal possédant une gamme dynamique étendue (5) à l'aide d'un convertisseur analogique/numérique (convertisseur A/D) (1), dont la gamme de mesure est plus petite que la gamme dynamique (15) du signal, et selon lequel la gamme dynamique (5) du signal est subdivisée en des sections de mesure (7,8,9) plus petite possédant la même étendue respective (6) que la gamme de mesure du convertisseur A/D (1), et selon lequel un sélecteur (2) des sections de mesure est commandé par des infomations de sortie du convertisseur A/D (1) de manière que le signal devant être numérisé soit situé dans la section sélectionnée de mesure (8) et qu'une section respective voisine de mesure (9) soit sélectionnée lorsque le signal dépasse par le haut ou par le bas des valeurs limites prédéterminées de la section actuelle respective de mesure (8), caractérisé par le fait qu'on utilise des sections de mesure (7,8,9), qui se chevauchent réciproquement, que lors du dépassement par le haut ou par le bas des valeurs limites dans la section actuelle respective de mesure (8), le signal parvient dans une zone limite de cette même section de mesure (8) et est numérisée dans cette zone, auquel cas une nouvelle section de mesure voisine (9) est choisie uniquement pour la numérisation immédiatement suivante du signal, et qu'une valeur numérique, qu'on utilise comme valeur de référence pour les valeurs du signal numérisées ensuite dans la nouvelle section de mesure (9), est extrapolée au moins à partir des deux informations numériques de sortie du convertisseur A/D (1), obtenues en dernier avant le changement de section de mesure (7,8,9).

2. Procédé suivant la revendication 1, caractérisé par le fait qu'on utilise la valeur extrapolée du signal en tant que première valeur dans la section de mesure modifiée.

3. Procédé suivant la revendication 1 ou 2, caractérisé par le fait qu'on forme chaque fois une différence entre la valeur actuelle du signal -détectée ou extrapolée- et la valeur précédente du signal et qu'on réalise une sommation continue de cette différence.

4. Procédé suivant la revendication 3, caractérisé par le fait que la valeur non extrapolée du signal, mesurée directement après le changement de la section de mesure, est la valeur initiale pour la formation immédiatement suivante de la différence.

5. Procédé suivant la revendication 1, caractérisé par le fait qu'on forme la différence entre la valeur numérique extrapolée et la première valeur du signal mesurée dans la nouvelle section de mesure et qu'on l'utilise pour corriger la position de cette section de mesure.

6. Dispositif de numérisation à haute résolution d'un signal comportant une gamme dynamique étendue (5), à l'aide d'un convertisseur A/D (1), dont la gamme de mesure est plus petite que la gamme dynamique (5) du signal, subdivisée en sections de mesure (7,8,9) de même grandeur, un étage logique (3) recevant les informations de sortie du convertisseur A/D (1) et servant à identifier 1'instant où le signal dépasse des valeurs limites prédéterminées de la section respective actuelle de mesure (8), et un sélecteur (2) des sections de mesure, dans lequel, lors d'un dépassement par le haut ou par le bas d'une valeur limite, un convertisseur numérique/analogique D/A (10) est commandé par l'étage logique (3) pour la sélection d'une section immédiatement suivante de mesure (9) et un amplificateur différentiel (11) branché en amont du convertisseur A/D (1) reçoit, à une entrée, le signal à numériser, tandis que son autre entrée est raccordée à la sortie du convertisseur D/A (10), caractérisé par le fait que l'étage logique (3) contient des moyens pour extrapoler une valeur numérique à partir au moins de la dernière des deux valeurs du signal numérisées avant la commutation dans la nouvelle gamme de mesure respective (9), et des moyens pour corriger les valeurs du signal, numérisées dans la nouvelle section de mesure (9), en fonction de la valeur numérique extrapolée.

7. Dispositif suivant la revendication 6, caractérisé par le fait qu'un microprocesseur est prévu en tant qu'étage logique.

8. Dispositif suivant la revendication 6 ou 7, caractérisé par le fait que le convertisseur A/D (1) est calibré au moyen du convertisseur D/A (10).

# FIG 1

# FIG 3

FIG 2

n+2

n+1

n

├─6

╭5

t

# FIG 4

# FIG 5

Einlesen von $S_n$ aus A/D Wandler — 12

$S_n > 3/4$ Messabschnitt      $S_n < 1/4$ Messabschnitt

DEC D/A — 17

Neue Diff. $S_n - S_{n-1}$ — 13

INC D/A — 18

14

15

16